Europäisches Patentamt

European Patent Office

Office européen des brevets

(19)

(11) Publication number: **0 076 730**
**A1**

(12)

# EUROPEAN PATENT APPLICATION

(21) Application number: **82401741.2**

(22) Date of filing: **27.09.82**

(51) Int. Cl.³: **C 23 C 3/00**

(30) Priority: **30.09.81 US 307058**

(43) Date of publication of application:
**13.04.83 Bulletin 83/15**

(84) Designated Contracting States:
**DE FR GB IT**

(71) Applicant: **THE BENDIX CORPORATION**
**Executive Offices Bendix Center**
**Southfield Michigan 48037(US)**

(72) Inventor: **Fogarty, John Francis**
**23 Siver St.**
**Sidney New York 13838(US)**

(72) Inventor: **Foote, William David**
**81A Algerine St.**
**Afton New York 13730(US)**

(74) Representative: **Brullé, Jean et al,**
**Service Brevets Bendix 44, rue François 1er**
**F-75008 Paris(FR)**

(54) A process for electroless metal plating of a polysulfone substrate.

(57) A process for electroless plating of a polysulfone substrate wherein the substrate is immersed in N-methyl-2-pyrrolidone as an initial etchant prior to the acid etching, sensitizing and activation, and electroless plating of a metal, such as nickel, on the substrate surface.

EP 0 076 730 A1

## A PROCESS FOR ELECTROLESS METAL PLATING OF A POLYSULFONE SUBSTRATE

This invention relates to a process for electroless plating of a polysulfone substrate with nickel or other metals.

Processes for the electroless plating of plastic substrates such as polysulfone substrates are known, wherein a substrate is immersed in a solvent for the plastic, for initial etching, rinsed with water and then contacted with an aqueous acid bath for further etching. The etched substrate is then subjected to known sensitizing and activating steps with the substrate then plated with a nickel or other metallic layer. The plated polysulfone substrates are then suitable for deposition thereon of conductive circuitry. An example of such a process may be found in U.S. 3,560,241 which teaches the use of a dual initial solvent treatment step where a polysulfone body is initially treated with a first solvent for dissolving a portion of the polysulfone and then with a second solvent miscible with the first solvent but which is a nonsolvent for polysulfone so as to deposit a mat of dissolved polysulfone on the substrate. This initially etched substrate is then contacted with an aqueous acid, rinsed, alkaline cleansed and acid neutralized, and subsequently a metallized layer deposited on the substrate. In more recent processes, a single solvent such as dimethylformamide has been used as an initial etchant for the polysulfone material. The use of dimethylformamide as such a solvent poses a problem however in view of the hazardous nature of the material.

### Disclosure of the Invention

This invention provides an electroless plating process for polysulfone substrates that uses a more acceptable solvent for initial etching of the substrate.

The invention is characterized by an electroless plating process which uses a N-methyl-2-pyrrolidone as an initial etchant for a polysulfone substrate, with the initially etched substrate then subjected to aqueous acid etching, sensitizing and activation, and electroless plating using commercially available electroless plating solutions.

Accordingly, it is an advantage of this invention to provide an electroless plating process for polysulfone substrates which uses a solvent for initial etching which is environmentally acceptable.

Another advantage of this invention is an improved electroless plating process for polysulfone substrates using a more stable initial etching solvent.

Detailed Description of the Invention

As discussed in U.S. 3,560,241, the contents of which are incorporated by reference herein, polysulfones are desirable as substrates in formation of printed circuit devices due to their excellent heat stability. In formation of such devices, a metal must be bonded to the substrate for subsequent deposition thereon of the conductive circuitry. One such polysulfone composition is sold by Union Carbide Corporation under the trademark "MINDEL M-825". A general discussion of forming a printed circuit on a polysulfone substrate is found in Union Carbide Technology Letter No. 106 entitled "Polysulfones as Printed Circuit Substrates", dated May 4, 1977, the contents of which are incorporated herein.

As discussed in said Technology Letter, electroless metal plating of polysulfones is effected by pretreating, or of initial etching, of the substrate by immersion in an organic solvent such as dimethylformamide (preconditioner). The substrate is then acid etched by immersion in a highly oxidizing acid such as a chromic acid-sulfuric acid mix, sensitized and activated by immersion in known solutions, and then subjected to electroless metal deposition.

In electroless plating of such polysulfone substrates according to the present invention, the polysulfone substrate is immersed in a light-duty cleaner, such as an alkaline, non-etch type of cleaner, rinsed with water, and dried. The polysulfone substrate is then immersed in an initial etching organic solvent consisting essentially of N-methyl-2-pyrrolidone (containing about 5% by volume of water) for a period of 25-35 seconds, preferably 30 seconds. This immersion in N-methyl-2-pyrrolidone provides an initial etching of the surface of the polysulfone substrate. The polysulfone substrate is then rinsed with cold water and conditioned by immersion in a chromic acid-sulfuric acid conditioner for a period of about 60 seconds. After rinsing with cold water, the conditioned polysulfone substrate is sensitized by immersion in a sensitizing solution such as Enplate Sensitizer 432 (Enthone Inc.). The sensitizing solution should contain about 1 part by volume Enplate Sensitizer 432 in 15 parts by volume of a solution of 90 parts water and 10 parts by volume of butyl cellosolve. After immersion in the sensitizing solution for a 6 minute time period, the sensitized polysulfone substrate is again rinsed with water and activated by immersion in an activating solution such as Enplate Activator 440 (Enthone Inc.). The activating solution should contain about 1 part by volume Enplate Activator 440 in 15 parts by volume of a solution of 90 parts water and 10 parts by volume butyl cellosolve. Following immersion in the activating solution for a period of about 195 seconds, the substrate is again rinsed with water. The activated polysulfone substrate is then metallized by immersion in an electroless nickel plating solution, such as Enplate Ni 410 (Enthone Inc.). Upon deposition of the nickel, the deposited metal film can have applied thereto silver or gold conductive paths.

The use of M-methyl-2-pyrrolidone as the initial etching solvent of the polysulfone substrate enables the use of a single initial etchant solvent which is stable at the operating temperatures encountered and which is less hazardous than other suggested solvents. The solvent, in addition to having a high flash point and low vapor hazard, exhibits good chemical and thermal stability.

**0076730**

CLAIMS:

1. A process for electroless metal plating of a polysulfone substrate wherein a polysulfone substrate is immersed in an organic solvent for initial etching pretreatment thereof prior to being contacted with an aqueous acid bath, sensitized, activated, and thereafter plated with an electroless plating solution, characterized in that N-methyl-2-pyrrolidone is used as said organic solvent.

2. The process for electroless metal plating as defined in claim 1, characterized in that said metal is nickel and that there is added to said solvent about 5 percent by volume water.

## EUROPEAN SEARCH REPORT

European Patent Office

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| | --- | | C 23 C 3/00 |
| A | FR-A- 209 978 (KOLLMORGEN) | | |
| | * page 4, lines 37-40; page 5, lines 1-19; page 10, line 31 * | | |
| | --- | | |
| A | DE-A-1 911 041 (IBM) | | |
| | ----- | | |

| | TECHNICAL FIELDS SEARCHED (Int. Cl. ³) |
|---|---|
| | C 23 C C 08 J |

The present search report has been drawn up for all claims

| Place of search THE HAGUE | Date of completion of the search 10-01-1983 | Examiner NGUYEN THE NGHIEP |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
 
& : member of the same patent family, corresponding document

EPO Form 1503 03 82